Europäisches Patentamt

European Patent Office

Office européen des brevets

(19)

(11) Veröffentlichungsnummer: **0 217 161**
**B1**

# (12) EUROPÄISCHE PATENTSCHRIFT

(45) Veröffentlichungstag der Patentschrift:
06.12.89

(51) Int. Cl.⁴: **H05K 7/14, H05K 7/18**

(21) Anmeldenummer: 86112159.8

(22) Anmeldetag: 02.09.86

(54) **Einrichtung zur Führung elektrischer Inneneinbauten mit Kunststoff-Führungsschienen.**

(30) Priorität: 05.09.85 DE 3531707

(43) Veröffentlichungstag der Anmeldung:
08.04.87 Patentblatt 87/15

(45) Bekanntmachung des Hinweises auf die Patenterteilung:
06.12.89 Patentblatt 89/49

(84) Benannte Vertragsstaaten:
CH DE FR GB IT LI NL

(56) Entgegenhaltungen:
EP-A- 0 125 160
DE-A- 2 806 284
DE-A- 3 105 165
DE-A- 3 110 717
DE-A- 3 209 205
DE-B- 1 119 920
DE-B- 1 282 758
US-A- 4 022 326

(73) Patentinhaber: Siemens Aktiengesellschaft,
Wittelsbacherplatz 2, D-8000 München 2(DE)
Patentinhaber: ANT Nachrichtentechnik GmbH,
Gerberstrasse 33, D-7150 Backnang(DE)

(72) Erfinder: Riedl, Friedrich, Dipl.-Ing. (FH),
Herbststrasse 15, D-8035 Gauting(DE)
Erfinder: Mayer, Franz, Wastl-Witt-Strasse 11,
D-8000 München 21(DE)
Erfinder: Stephan, Roland, Ing. grad.,
Glasäckerstrasse 33, D-7151 Allmersbach i.T.(DE)
Erfinder: Hirsch, Gerhard, Ing. grad., Häfnersweg 66,
D-7150 Backnang(DE)
Erfinder: Latsch, Wolfgang, Dipl.-Ing. (FH),
Hermann-Hesse-Weg 2, D-7151 Auenwald(DE)

(74) Vertreter: Mehl, Ernst, Dipl.-Ing. et al, Postfach 22 13 17,
D-8000 München 22(DE)

## Beschreibung

Die Erfindung betrifft eine Einrichtung zur Führung elektrischer Inneneinbauten, wie z.B. Leiterplatten, Steckbaugruppen oder Einschübe, mit zwei einander gegenüberliegenden Profil-Trägerplatten sowie mit mindestens zwei parallel und senkrecht übereinander liegenden, aus elastischem Kunststoff bestehenden und mit einer Führungsnut für die Inneneinbauten versehenen Führungsschienen, die bezüglich einer ihre Länge halbierenden Ebene symmetrisch aufgebaut und an der der jeweiligen Profil-Trägerplatte zugekehrten Unterseite mit zwei entgegengesetzt gerichteten Einschnapphaken ausgebildet sind, die in jeweils eine Nut der jeweiligen Profil-Trägerplatte eingreifen, und mit zwei ein Teilungsraster aufweisenden, parallelen, senkrecht übereinander liegenden und senkrecht zu den Führungsschienen verlaufenden Rasterschienen, die je auf einer der Profilträgerplatten angeordnet sind.

Zum Einbau elektrischer Inneneinbauten, wie z.B. Leiterplatten, Steckbaugruppen oder Einschübe, in Einschub oder Baugruppenträger, z.B. in Gehäuse für elektrische Geräte, werden häufig Führungsschienen mit einer Führungsnut zum Einschieben oder Einstecken der Inneneinbauten verwendet. Um die Inneneinbauten an verschiedenen Plätzen eines Teilungsrasters anordnen und die Führungsschienen an allen möglichen Steckplätzen im Raster seitlich fixieren zu können, benutzt man Rasterschienen, die mit einem Teilungsraster ausgebildet sind, in das die Führungsschienen mit Rastmitteln eingreifen. Derartige Raster- und Führungsschienen sind in vielfältigen Ausführungsformen bekannt.

Aus der DE-OS 31 10 717 ist ein aus einer Profil-Trägerplatte bestehender Baugruppenträger mit Führungsleisten und zwei Rastschienen für Leiterplatten bekannt, bei dem die mit einer Führungsnut versehenen Führungsleisten bezüglich einer ihrer Länge halbierenden Ebene symmetrisch aufgebaut und an der Profil-Trägerplatte zugekehrten Unterseite mit zwei entgegengesetzt gerichteten hakenförmigen Rastnasen ausgebildet sind, die in Nuten der Profil-Trägerplatte eingreifen, in welchen die Rastschienen unter den Führungsleisten liegend angeordnet sind. Diese bekannten Führungsleisten sind zwar selbst schraubenlos duch Einrasten in die Profilierung auf einfache Weise an der Profil-Trägerplatte gehalten, bieten aber keine Möglichkeit zur sicheren Halterung der Leiterplatten in der Führungsnut, d.h. die Leiterplatten sind nicht gegen ein Herausziehen gesichert. Bei dem bekannten Baugruppenträger sind außerdem auch keine Mittel zur Verdrahtung der Leiterplatten untereinander vorgesehen und demzufolge auch nicht in das Führungs- und Montagesystem der Leiterplatten einbezogen. Diese bedeutet, daß evtl. vorzusehende Verdrahtungsmittel gesondert in dem Baugruppenträger angebracht und befestigt werden müßten.

In der DE-PS 1 271 793 ist eine Geräteeinheit zur Aufnahme von Steckbaugruppen angegeben, die aus elastischem Kunststoff bestehende Führungsschienen aufweist. Dabei können die Führungsschienen aufgrund ihrer symmetrischen Gestaltung und der zur Führungsnut seitlich versetzten hakenförmigen Rastnasen auf Umschlag so in das Teilungsraster des profilierten Aufnahmebleches eingesetzt werden, daß durch Drehen einer Führungsschiene um 180° zwei um einen halben Rasterschritt versetzte Führungsschienen lagen I und II möglich sind. Darüber hinaus sind bei der bekannten Geräteeinheit in der eingehakten Stellung der Führungsschienen auch die den Steckbaugruppen zugeordneten Federleisten gegen den Träger verklemmend gehalten. Es sind jedoch ebenfalls keine Mittel für die Verdrahtung der Steckbaugruppen untereinander vorgesehen und in deren Führungs- und Montagesystem mit einbezogen. Außerdem sind auch bei diesen Führungsschienen die Steckbaugruppen nicht gegen ein Herausziehen aus der Führungsnut gesichert, so daß auch bei dieser Geräteeinheit lediglich die Halterung der Führungsschienen selbst einfach durch Einrasten in das Profilblech erfolgt.

Aus der DE-AS 21 19 709 ist ein Baugruppenträger zur Aufnahme einschiebbarer elektrischer Baugruppen mit Führungs- und Rasterschienen bekannt, wobei die Rasterschienen, von denen jeweils zwei horizontal parallel liegen, ein- oder mehrzeilig angeordnet sind und die Führungsschienen in die darunter liegenden Rasterschienen eingerastet sind. Zur Verdrahtung der einzelnen Baugruppen untereinander ist an der Rückseite des Baugruppenträgers ein Verdrahtungsfeld in Form einer geätzten Leiterplatte vorgesehen, welche die gesamte Rückseite des Baugruppenträgers bedeckt. Das Verdrahtungsfeld wird über Schraub- oder Rastverbindungen an den Enden der Führungsschienen befestigt. Dazu sind die Führungsschienen an ihrem hinteren Ende entweder gerade vertikal abgeschnitten und mit einer Bohrung zur Aufnahme der Schrauben oder mit Rastzapfen versehen, die gegebenenfalls in entsprechende Aussparungen innerhalb der Leiterplatte des Verdrahtungsfeldes eingreifen. Bei diesem bekannten Baugruppenträger ist also das Verdrahtungsfeld und seine Befestigung in das Führungssystem mit einbezogen. Dabei kann das Verdrahtungsfeld leicht ein- und ausgebaut werden, ohne weitere Bauteile des Baugruppenträgers lösen oder ausbauen zu müssen. Abgesehen davon, daß auch bei diesem Baugruppenträger jeweils zwei Rasterschienen erforderlich und diese unter den Führungsschienen liegend angeordnet sind, sind die Baugruppen lediglich in die Führungsschienen eingeschoben und nicht in diesen gegen ein Herausziehen gesichert. Außerdem können die Führungsschienen aufgrund ihrer unsymmetrischen Ausbildung nicht auf Umschlag in den Baugruppenträger eingesetzt werden.

Eine weitere Anordnung zur Befestigung und Halterung von Leiterplatten ist aus der DE-OS 25 14 048 bekannt. Diese Halterung besteht im wesentlichen aus Tragleisten mit einem sägezahnförmigen L-Profil, die Rasterschienen bilden und aus Führungsschienen mit einer Führungsrille zum Einschieben der Leiterplatten. Die Führungsschienen wirken an einem Ende mit den Rasterschienen zusammen und sind hierzu T-förmig ausgebildet und mit einer U-förmigen Klammer versehen. Damit umgreifen sie das L-Profil der Tragleisten. Am anderen mit einer Rückwand zusammenwirkenden Ende weisen die Führungsschienen eine doppelte Federklinke auf, die in die der elektrischen Verbindung der Leiterplatten untereinander dienende Rückwand eingreifen. Bei dieser bekannten Anordnung dienen die Rasterschienen und die Rückwand gleichzeitig als Trageelemente für die Führungsschienen, eigene Rast- oder Halterungsmittel für die Führungsschienen sind somit nicht vorgesehen. Die Halterung der Führungsschienen ist also erst möglich, wenn Rückwand und Rasterschienen bereits fest vorhanden sind. Dies ist nicht nur bei der Montage, sondern auch bei Auswechslungen von erheblichem Nachteil. Außerdem sind auch hier die Leiterplatten nicht gegen Herausziehen aus den Führungsschienen gesichert und die Führungsschienen unsymmetrisch ausgebildet.

Aus der DE-OS 31 05 165 ist eine aus Kunststoff bestehende Führungsschiene für Leiterplatten bekannt, die an einem Ende einen Schnappverbinder aufweist, der in einem Gehäuserahmen einrastet, während am anderen Ende mindestens ein sich als Fortsatz an der Stirnseite in Längsrichtung der Führungsschiene weiter erstreckender Stift vorgesehen ist, der in entsprechende Bohrungen an der Rückseite des Gehäuserahmens oder einer an der Rückseite des Gehäuserahmens befestigten Leiterplatte eingreift. Damit wird erreicht, daß die Führungsschiene zu einem auf der zuletzt genannten Leiterplatte befestigten Steckverbinder immer die gleiche Lage einnimmt. Bei der bekannten Führungsschiene sind die in die Führungsnut einschiebbaren Leiterplatten aber ebenfalls nicht gegen Herausziehen gesichert. Außerdem ist die Führungsschiene unsymmetrisch ausgebildet und weist als eigene Haltemittel lediglich den Schnappverbinder und die endseitigen Stifte auf, so daß zur Fixierung einer Führungsschiene unbedingt eine Rückwand oder eine an der Rückwand des Gehäuserahmens befestigte Leiterplatte erforderlich ist. Schließlich ist bei der bekannten Anordnung keine Rasterschiene vorgesehen.

Die DE-AS 1 119 920 zeigt einen Einschubträger zur Aufnahme von Bauelemente tragenden Einschüben mit durch mehrere Schlitzreihen im Einschubträger gebildeten Rasterschienen und darin eingehakten Führungsschienen, die mit Haken, Arretier- und Führungsnasen ausgebildet sind und in eingehakter Stellung mit ihrem hinteren Ende die zugeordnete Federleiste sowohl gegen den Einschubträger verklemmend als auch seitlich unverrückbar in ihrer Lage halten. Verdrahtungsmittel sind bei dem bekannten Einschubträger aber nicht vorgesehen. Darüber hinaus sind die aus Kunststoff bestehenden Führungsschienen etwa in der Mitte ihrer Länge mit Nockenfedern ausgebildet, die in Ausnehmungen der plattenförmigen Einschübe greifen und diese in ihrer eingeschobenen Lage sichern. Beim Lösen eines Einschubes ist es demzufolge aber erforderlich, daß die Führungsschienen im Bereich der Nockenfedern zugänglich bleiben. Außerdem sind die Führungsschienen unsymmetrisch ausgebildet, so daß sie nur in einer Richtung in die Schlitzreihen eingesetzt werden können.

Schließlich ist in der DE-PS 2 348 492 noch ein Werkzeug zum Ziehen von in Führungsschienen angeordneten Steckbaugruppen angegeben, die in der Steckendstellung mit im Bereich der Bedienungsfrontseite angeordneten Rastkanten an einem federnden Rasthaken verrasten, welcher am Anfang der Führungsschiene an einem Federarm vorgesehen ist und in der entspannten Stellung in die Führungsnut ragt. Auf diese Weise lassen sich Steckbaugruppen gegen ein Herausziehen aus den Führungsschienen sichern.

Die vielfältigen Ausführungsformen von Führungsschienen zeigen, daß es bekannt ist, Führungsschienen so auszubilden, daß sie selbst durch Einrasten einfach zu fixieren sind, durch Ausbildung mit Nockenfedern oder federnden Rasthaken Leiterplatten, Steckbaugruppen oder Einschübe gegen ein Herausziehen sichern, durch symmetrische Ausbildung auf Umschlag einsetzbar sind oder an einem Ende mit Rastmitteln in ein gemeinsames Verdrahtungsfeld eingreifen. Trotzdem weist jedoch keine Führungsschiene alle diese Eigenschaften gleichzeitig auf, so daß bei Verwendung der bekannten Führungsschienen stets mindestens einer der geschilderten Nachteile in Kauf genommen werden muß.

Der Erfindung liegt daher die Aufgabe zugrunde, eine Einrichtung zur Führung elektrischer Inneneinbauten mit zwei einander gegenüberliegenden Profilträgerplatten zu schaffen, die einen völlig werkzeuglosen Einbau der Kunststoff-Führungsschienen selbst sowie der in die Führungsschienen einschiebbaren Inneneinbauten und einer gemeinsamen das Führungssystem einbezogenen Verdrahtungsplatte bei sicherer Fixierung der einzelnen Komponenten ermöglicht.

Diese Aufgabe wird bei einer Einrichtung der eingangs genannten Art gemäß der Erfindung durch die Kombination folgender Merkmale gelöst:

a) die Führungsnut der Führungsschienen ist im Bereich beider Enden mit jeweils einem seitlichen Federarm ausgebildet, der an seinem freien Ende mit einer im entspannten Zustand in die Führungsnut ragenden, widerhakenartig geformten Rastnase versehen ist, die hinter eine Rastkante der Inneneinbauten greift, welche in einem im eingeschobenen Zustand am Anfang der Führungsnut liegenden Bereich der Inneneinbauten vorgesehen ist,

b) an beiden Enden der Führungsschienen ist jeweils ein an der Stirnseite der Führungsschiene angeordneter, auf die jeweilige Profil-Trägerplatte gerichteter Zentrierhaken vorgesehen,

c) die Führungsschienen sind mit dem Zentrierhaken in das Teilungsraster der vor der einen Stirnseite der Führungsschienen angeordneten Rasterschienen bzw. in im Teilungsraster der Rasterschienen liegende Aussparungen einer für die Verdrahtung der Inneneinbauten untereinander vor der anderen Stirnseite der Führungsschienen vorgesehenen Verdrahtungsplatte eingehängt, so daß dadurch die Führungsschienen seitlich im Teilungsraster fixiert sind und gleichzeitig die Verdrahtungsplatte an der jeweiligen Profil-Trägerplatte gehalten ist.

Bei einer derartigen Einrichtung sind die Kunststoff-Führungsschienen, die völlig symmetrisch bezüglich einer ihre Länge halbierenden Ebene aufgebaut sind, so ausgebildet, daß sie sowohl in einer ersten Position als auch auf Umschlag, d.h. nach einer Drehung um 180°, lediglich durch Einschnappen, Ein- oder Verrasten sowohl in die Profilierung der jeweiligen Profil-Trägerplatte als auch in die Rasterschienen und in die Verdrahtungsplatte einsetzbar sind. Durch die Drehung um 180° wird eine Rasterhalbierung ermöglicht. Dabei ist für mehrere in einer Ebene auf einer Profil-Trägerplatte angeordnete Führungsschienen lediglich eine Rasterschiene erforderlich, da die Funktion einer zweiten Rasterschiene von der mit entsprechenden Aussparungen versehenen Verdrahtungsplatteausgeübt wird. Diese Verdrahtungsplatte ist durch Einrasten von jeweils zwei parallel übereinander z.B. auf der Boden- und der Deckplatte eines Gehäuses angeordneten Führungsschienen an der Trägerplatte fixierbar und zwar dadurch, daß der Zentrierhaken am betreffenden Ende der bereits in die Profilierung der Trägerplatte eingesetzten Führungsschienen in die Verdrahtungsplatte eingehängt wird. Die auf diese Weise in das Montage- und Führungssystem für die Inneneinbauten integrierte Verdrahtungsplatte ist dann – ohne daß ein Lösen oder Entfernen der Führungsschienen oder sonstiger Komponenten erforderlich wäre – ohne weiteres wieder herausnehmbar. Dies gilt auch für die Rasterschienen, da die Rasterschienen wie die Verdrahtungsplatte vor einer Stirnseite der Führungsschienen liegend angeordnet sind und die Führungsschienen lediglich mit dem anderen Zentrierhaken in die Rasterschienen eingreifen. Darüber hinaus sind Inneneinbauten im die Führungsschienen eingeschobenen Zustand durch einen der Federarme der Führungsnut verriegelt, d.h. gegen Herausziehen gesichert. Durch die Zugänglichkeit der Federarme an den Enden der Führungsschienen ist eine Entriegelung auf einfach durchzuführende Weise möglich. Bei einer erfindungsgemäßen Einrichtung ist somit gleichzeitig eine werkzeuglose Halterung der Führungsschienen im Teilungsraster, der Inneneinbauten in den Führungsschienen und der gemeinsamen Verdrahtungsplatte an den Führungsschienen gewährleistet. Diese kostengünstige und schnell durchzuführende Montage wird lediglich durch die Gestaltung der Kunststoff-Führungsschienen und ohne zusätzliche Elemente erreicht. Die Kunststoff-Führungsschienen bilden somit in vorteilhafter Weise eine integrale Komponente eines aus Kunststoff-Teilen herstellbaren Einschnapp-Montagesystems zum Einbau von Inneneinbauten und deren Verdrahtung, z.B. in Gehäuse für elektrische Geräte.

Vorteilhafte Ausgestaltungen des Gegenstandes des Patentanspruchs 1 sind in den Unteransprüchen angegeben.

Besonders zweckmäßig ist es, wenn die Führungsnut der Führungsschienen im Verlauf ihrer Längserstreckung mit zwei weiteren Federarmen ausgebildet ist, die an ihrem freien Ende eine im entspannten Zustand in die Führungsnut ragende Nase aufweisen. Damit ist gewährleistet, daß die Inneneinbauten auch im Verlauf der Längserstreckung fest gegen eine Seitenwand der Führungsnut angedrückt werden und somit ohne Klappergeräusche in den Führungsschienen gehalten sind.

Dabei ist es vorteilhaft, wenn die Führungsschienen an dem freien Ende der weiteren Federarme mit jeweils einer Aussparung ausgebildet sind, in die jeweils eine weitere Verdrahtungsplatte in einer Zwischenebene einsetzbar ist. Hierbei werden die weiteren Verdrahtungsplatten derart mit einer Ausnehmung versehen, daß die Verdrahtungsplatten im Bereich ihrer Ausnehmung den Querschnitt der Führungsschiene im Bereich der Aussparungen an den freien Enden eines weiteren Federarmes eng umschließen. Auf diese Weise können auch zusätzliche Verdrahtungsplatten einfach an den Profil-Trägerplatten gehalten werden.

Die Erfindung ist im folgenden anhand eines in der Zeichnung dargestellten Ausführungsbeispiels der Einrichtung und der Anwendung einer solchen Einrichtung beim Aufbau eines Gehäuses für elektrische Geräte näher beschrieben.

Es zeigen

Fig. 1 ein Gehäuse für elektrische Geräte im Querschnitt und im geöffneten Zustand, d.h. ohne Frontplatte und ohne Rückwand,

Fig. 2 eine Ansicht in Richtung A einer zum Aufbau des Gehäuses verwendeten Profil-Trägerplatte mit einem Montage-, Führungs- und Halterungssystem für die Inneneinbauten des Gehäuses,

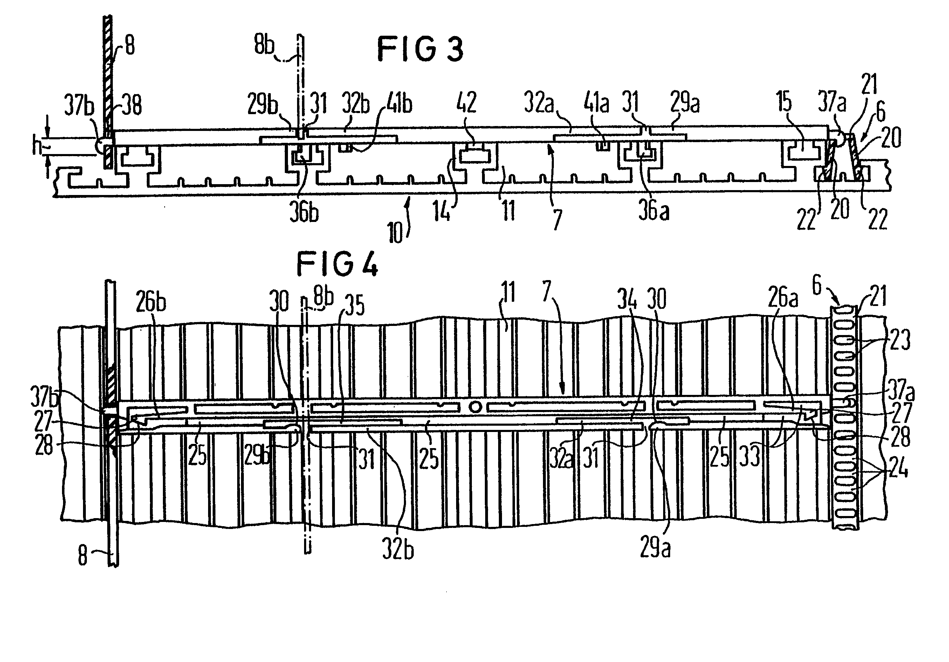

Fig. 3 und 4 in Seitenansicht bzw. Draufsicht eine in die Profil-Trägerplatte eingesetzte Führungsschiene mit Rasterschiene und Verdrahtungsplatte.

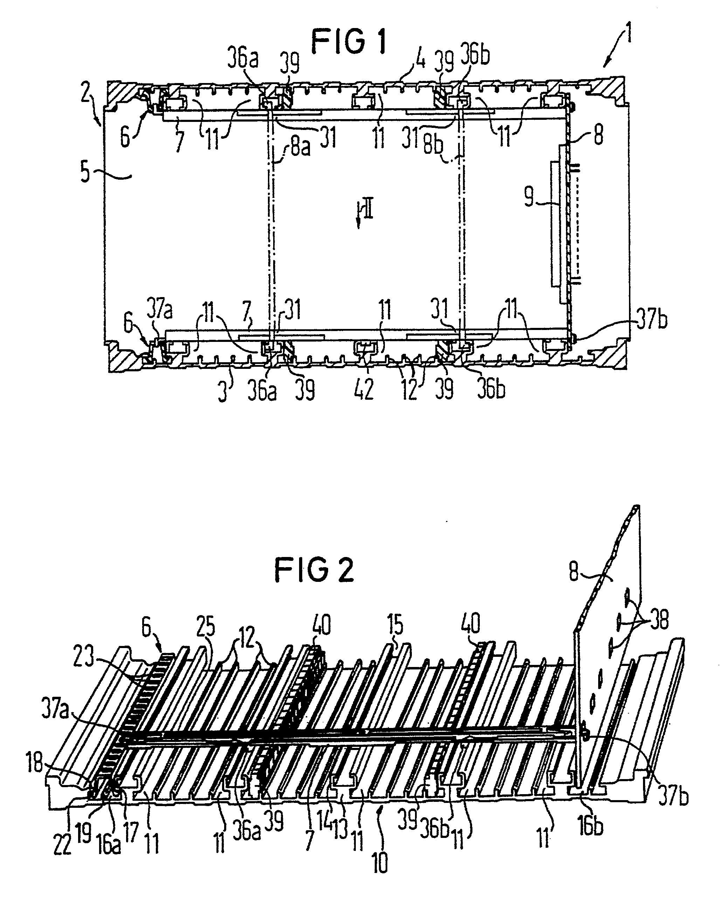

Das Gehäuse 1 in Fig. 1 hat einen kastenförmigen Rahmen oder Mantel 2, der aus zwei einander gegenüberliegenden Mittelteilen, nämlich einer Bodenplatte 3 und einer Deckplatte 4, sowie aus zwei damit dicht verbundenen Seitenwänden, von denen in Fig.1 nur die Seitenwand 5 zu sehen ist, besteht. An den beiden offenen Seiten ist der Gehäusemantel mit einer abschraubbaren oder abklappbaren Frontplatte und einer Rückwand, die beide nicht dargestellt sind, dicht verschließbar. Dabei kann die Wasserund HF-Dichtigkeit des Gehäuses dadurch gewährleistet werden, daß die Mittelteile und die Seitenwände an den vier Kanten durch geeignete Schweißverfahren dicht verbunden sind und eine kombinierte Gummi-DrahtDichtungsschnur jeweils in eine Nut der Frontplatte und der Rückwand eingelegt ist. Insgesamt ist das Gehäuse in seinem grundsätzlichen Aufbau wie die z.B. in der DE-AS 25 23 292, der DE-PS 25 38 314 und der DE-PS 24 43 122 beschriebene und unter dem Warenzeichen "SIDISET" bekanntgewordene Gehäusebaureihe ausgebildet, wobei für das vorliegende Gehäuse gegebenenfalls einzelne Teile, wie z.B. die Frontplatte und die Rückwand, aus dem bekannten System verwendet werden können. Die die Inneneinbauten, wie z.B. nicht dargestellte Leiterplatten, Steckbaugruppen oder Einschübe tragenden Mittelteile 3,4 sind jeweils von einer Profil-Trägerplatte aus einem Aluminium-Strangpreßprofil mit einem zu zwei einander gegenüberliegenden Plattenrändern, hier zur Front- und zur Rückseite parallelen Profilverlauf in Richtung der Gehäusebreite gebildet. Alle im Gehäusemantel 2 aufgenommenen Inneneinbauten sind über Führungs-, Rast- und Verdrahtungsmittel an den die Boden- und die Deckplatte 3 bzw. 4 bildenden, in besonderer Weise gestalteten ProfilTrägerplatten angeordnet, die hier also zusammen mit den genannten Mitteln die Montage- und Halterungseinrichtung für die Inneneinbauten bilden. Der Aufbau einer solchen Einrichtung ist im folgenden anhand der Fig. 2 beschrieben. Diese Figur zeigt ein Teilstück eines die Bodenplatte 3 bildenden, als Profil-Trägerplatte 10 ausgebildeten Mittelteiles 3. Das die Deckplatte 4 bildende Mittelteil ist - wie sich aus Fig. 1 ergibt - in gleicher Weise gestaltet und daher in Fig.2 nicht näher dargestellt. Die Einrichtung besteht im vorliegenden Fall also aus beiden Mittelteilen 3 und 4, d.h. aus zwei ProfilTrägerplatten 10, die mit zwei parallelen, senkrecht übereinander liegenden Rasterschienen 6 und mehreren, paarweise einander parallel gegenüberliegenden und senkrecht zu den Rasterschienen verlaufenden Führungsschienen 7 ausgebildet sind, so daß jeweils zwischen einer unteren und der senkrecht direkt darüber liegenden Führungsschiene z.B. eine Leiterplatte oder eine Steckbaugruppe in das Gehäuse 1 einschiebbar ist. Außerdem ist noch eine gemeinsame Verdrahtungsplatte 8 zur Verdrahtung der Leiterplatten oder Steckbaugruppen untereinander vorgesehen, wobei die Verdrahtungsplatte -wie auch die Leiterplatten oder Steckbaugruppen - mit einer Steckerleiste 9 ausgebildet ist, z.B. aus einer geätzten Leiterplatte besteht und sich über die gesamte Rückseite des Gehäusemantels 2 erstrecken kann.

Die einzelnen Komponenten der Einrichtung, nämlich die Profil-Trägerplatte 10, die Rasterschiene 6, die Füh rungsschienen 7 und die Verdrahtungsplatte 8 sind im einzelnen nun wie folgt gestaltet. Die Profil-Trägerplatte 10 hat einen regelmäßigen Profilverlauf mit gleichmäßig innerhalb des die Inneneinbauten aufnehmenden Bereiches verteilten Profilrippen 11 und Kühlrippen 12. Dabei sind auf der hier etwa 2 mm dicken Profil-Trägerplatte 10 fünf Profilrippen 11 vorgesehen, die in gleichem Abstand voneinander angeordnet sind und zu zwei einander parallel gegenüberliegenden Plattenrändern, also zur Front- und zur Rückseite, und zueinander parallel verlaufen. Zwischen jeweils zwei Profilrippen 11 sind vier Kühlrippen 12 vorgesehen, die in gleichem Abstand voneinander angeordnet sind und parallel zu den Profilrippen und zueinander verlaufen. Die Profilrippen 11 bestehen aus einem zur Ebene der Profil-Trägerplatte 10 senkrechten Steg 13 und einer auf diesem Steg liegend angeordneten C-Profilschiene 14 mit einer zu den Inneneinbauten hin offenen T-Nut 15, wobei die C-Profilschiene 14 über beide senkrechte Seiten des Steges hinausragt und hier symmetrisch in Bezug auf eine sich in Längsrichtung der Profilrippe 11 erstreckende Symmetrielinie des Steges angeordnet ist. Dabei bildet der Steg der Profilrippen als Ständer oder Stütze für die die eigentliche Auflage für die Inneneinbauten bzw. deren Rast- und Führungsmittel übernehmende C-Profilschiene eine Art Wärmeableitsteg, während insbesondere durch die Form der Profilrippen und durch die zwischen den Profilrippen angeordneten Kühlrippen von der Höhe etwa des Steges vor allem die Oberfläche zur Wärmeabsorption vergrößert wird. Zudem wird dadurch eine hohe Formstabilität bei möglichst geringem Gewicht der Profil-Trägerplatte erreicht. Außerdem bietet die Form der C-Profilschiene 14 vielfältige variable Befestigungsmöglichkeiten für die Inneneinbauten bzw. deren Führungsmittel. Die Inneneinbauten können schraubenlos - falls erforderlich aber auch schraubbar mittels Gleit- oder Schiebemuttern - mit Hilfe der durch Einrasten oder Einschnappen in den C-Profilschienen 14 zu halternden Führungsschienen 7 an beliebigen Stellen der Profil-Trägerplatte befestigt werden. Damit bilden die C-Profilschienen gleichzeitig auch Montageschienen, welche die Anwendung einer Einschnapp-Montagetechnik für die Gehäuseeinbauten bzw. deren Führungs- und Rastmittel ermöglichen. Für den Einbau dieser Mittel ist die Profil-Trägerplatte 10 außerhalb des die Inneneinbauten aufnehmenden Bereiches zwischen den beiden äußersten Profilrippen 11 und dem jeweiligen Rand der Trägerplatte an der Front- bzw. an der Rückseite des Gehäuses noch mit einer zu den Inneneinbauten hin offenen Nut 16a bzw. 16b ausgebildet. Diese Nut ist einerseits durch die außenliegende, eine Hinterschneidung 17 bildende Schulter der entsprechenden C-Profilschiene 14 der äußersten Profilrippe 11 und andererseits durch eine hierzu gegenüberliegende Hinterschneidung 18 der Trägerplatte 10 T-förmig gestaltet und weist etwa in ihrer Mitte eine Rippe 19 auf, die gegenüber den Külrippen 12 etwas niedriger ist. Die nahe der Gehäusefrontseite befindliche Nut 16a dient zum Einsetzen der mit einem Teilungsraster ausgebildeten Rasterschiene 6, während in die nahe der Gehäuserückseite befindliche Nut 16b die gemeinsame Verdrahtungsplatte 8 senkrecht zur Trägerplatte und zur Einschubrichtung der Inneneinbauten stehend und gegebenenfalls an der C-Profilschiene 14 der anderen äußersten Profilrippe 11 anliegend eingesetzt ist. Die Rasterschiene 6 besteht aus einem im Querschnitt U-förmigen Kunststoffteil, dessen Schenkel 20 etwas nach außen gespreizt sind, so daß sie mit dem das Teilungsraster aufweisenden Mittelteil 21 einen Winkel von etwas mehr als 90° einschließen. Außerdem sind die Schenkel 20 der Rasterschiene 6 an ihrem freien Ende mit nach außen gerichteten Widerhaken 22 versehen. Damit ist die von oben her in die in ihrer Öffnung entsprechend dimensionierte Nut 16a einsetzbare und mit ihrer Länge der Gehäusebreite entsprechende Rasterschiene 6 unter Klemmung in der Nut fixierbar. Das Teilungsraster auf dem Mittelteil 21 der Rasterschiene 6 besteht aus einem Lochraster, das von einer Vielzahl von quer zur Nut 16a in Einschubrichtung der Inneneinbauten sich erstreckenden, langlochähnlichen Aussparungen 23 gebildet ist und z.B. durch fortlaufende Zählnummern oder Buchstaben auf den zwischen den Aussparungen 23 stehenbleibenden Stegen 24 gekennzeichnet werden kann.

Die aus elastischem Kunststoff bestehenden Führungsschienen 7 sind bezüglich einer ihre Länge halbierenden Ebene symmetrisch aufgebaut und zur Aufnahme von Inneneinbauten, z.B. zum Einschieben einer Leiterplatte mit einer Führungsnut 25 ausgebildet, die hier seitlich einer sich in Längsrichtung der Führungsschiene erstreckenden Symmetrielinie verläuft. Um die Leiterplatte einfach in der Führungsnut 25 verriegeln zu können, ist die Führungsnut im Bereich beider Enden der Führungsschiene 7 mit jeweils einem seitlichen Federarm 26a bzw. 26b ausgebildet, der an seinem freien Ende mit einer widerhakenartig geformten Rastnase 27 mit Anlaufschräge 28 versehen ist, wobei die Rastnase 27 im entspannten Zustand des Federarmes 26a, 26b in die Führungsnut 25 ragt. Dementsprechend ist die in die Führungsnut einzuschiebende Leiterplatte dann in dem Bereich, der im eingeschobenen Zustand am Anfang der Führungsnut liegt, mit einer z.B. durch eine Aussparung gebildeten Rastkante versehen, in welche die Rastnase 27 in vollständig in die Führungsschiene 7 eingeschobenem Zustand der Leiterplatte zu deren Verriegelung in der Führungsnut einrastet. Um die Leiterplatte dann möglichst spielfrei in dieser Führungsnut zu führen und zu halten, ist die Führungsnut 25 der Führungsschienen 7 im Verlauf ihrer Längserstreckung mit zwei weiteren Federarmen 29a bzw. 29b ausgebildet, die an ihrem freien Ende eine im entspannten Zustand ebenfalls in die Führungsnut ragende Nase 30 aufweisen. Die Federarme 29a, 29b sind hier etwa ein Viertel der Länge der Führungsschiene von deren Enden entfernt symmetrisch in bezug auf die Mitte der Länge der Führungsschiene vorgesehen und so angeordnet, daß jeweils in einem über der Öffnung der T-Nut 15 der beiden entsprechenden C-Profilschienen 14 liegenden Bereich am freien Ende eines Federarmes, also neben der Nase 30, eine Aussparung 31 gebildet ist. Dadurch können hier zwei weitere Verdrahtungsplatten 8a und 8b in zwei zusätzlichen Zwischenebenen angebracht werden. Die zusätzlichen Verdrahtungsplatten sind in diesem Bereich jeweils so ausgespart, daß sie den Querschnitt der Führungsschienen 7 im Bereich der Aussparungen 31 eng umschließen. Die Verdrahtungsplatten 8a und 8b sind dann im in die Aussparungen 31 und die darunter liegende T-Nut 15 der C-Profilschienen 14 eingesetzten Zustand - wie in Fig. 1 gezeigt - durch die Aussparungen 31 zweier senkrecht übereinander liegender Führungsschienen 7 in den Zwischenebenen gehalten. Anschließend an die Aussparungen 31 ist die Führungsnut 25 der Führungsschienen 7 nochmals mit sich in Längsrichtung erstreckenden seitlichen Federarmen 32a bzw. 32b ohne Rastnase ausgebildet. Diese Federarme bilden einen der beiden Anschläge für die Verdrahtungsplatten 8a und 8b in Längsrichtung der Führungsschienen und ermöglichen infolge ihrer federnden Eigenschaften eine Entriegelung der Verdrahtungsplatten 8a und 8b. Sämtliche Federarme der Führungsnut 25 sind durch Ausnehmungen 33, 34 und 35 der Führungsschienen gebildet.

Die schraubenlose Halterung der Führungsschienen 7 erfolgt über zwei an deren der Trägerplatte 10 zugewandten Unterseite vorgesehene, entgegengesetzt gerichtete, d.h. in bezug auf die Mitte der Länge der Führungsschienen symmetrisch angeordnete, L-förmige Einschnapphaken 36a bzw. 36 b, welche in die C-Profilschienen 14 einrasten.

Die Einschnapphaken sind auf der der Führungsnut 25 gegenüber liegenden Seite der Symmetrielinie der Führungsschienen angeordnet. Ebenfalls auf dieser Seite der Symmetrielinie befindet sich in einer Flucht mit den Einschnapphaken liegend an der Stirnseite beider Enden der Führungsschiene jeweils eine auf die Trägerplatte zu gerichteter L-förmiger Zentrierhaken 37a bzw. 37b, der zur Führungsnut 25 um eine Teilung des Rastermaßes versetzt ist. Mit dem Zentrierhaken 37a an dem einen Ende sind die Führungsschienen 7 in das Teilungsraster der vor der vorderen Stirnseite der Führungsschienen angeordneten Rasterschiene 6 und mit dem Zentrierhaken 37b an dem anderen Enden in im Teilungsraster angeordnete Aussparungen 38 der vor der hinteren Stirnseite vorgesehenen Verdrahtungsplatte 8 eingehängt. Dadurch wird im Zusammenwirken mit der in Fig. 2 nicht dargestellten, in gleicher Weise ausgebildeten Deckplatte 4 des Gehäuses 1 gleichzeitig die seitliche Fixierung der Führungsschienen 7 im Teilungsraster und die schraubenlose Halterung der Verdrahtungsplatte 8 in der Nut 16b der Trägerplatte 10 bewirkt. Die Aussparungen 38 der gemeinsamen Verdrahtungsplatte 8 sind in Höhe der auf den C-Profilschienen der Trägerplatte aufliegenden Führungsschienen angeordnet und als Langlöcher ausgebildet, die sich mit ihrer Längsrichtung senkrecht zur Ebene der Trägerplatte erstrecken. Dabei ist die Länge der Langlöcher 38 etwa mindestens gleich der Höhe h der Zentrierhaken 37a, 37b und die Breite der Langlöcher wie auch die Breite der Aussparungen 23 der Rasterschiene 6 etwa gleich der lichten Außenweite, z.B. etwa gleich dem Außendurchmesser der Zentrierhaken.

Für eine weitere Fixierung der Führungsschienen 7 im Teilungsraster sind noch zwei entsprechend gezahnte Stützschienen 39 mit einer der Gehäusebreite entsprechenden Länge vorgesehen und im Verlauf der Längserstreckung der Führungsschienen im ersten und zweiten Drittel des Strangpreßprofils neben zwei C-Profilschienen von oben her in die Profilierung eingesetzt. Die Stützschienen 39 sind - wie auch die Rasterschienen 6 - durch Einpassen in der Länge zwischen den Gehäuseseitenwänden gegen seitliches Verschieben gesichert. Die aufgrund ihres völlig symmetrischen Aufbaus auf Umschlag, d.h. auch bei Drehung um 180°, sowohl in die Bodenplatte 3 als auch in die Deckplatte 4 sowie in die Rasterschienen 6 und die Verdrahtungsplatte 8 einsetzbaren Führungsschienen 7 sind dazu an der den Stützschienen 39 zugekehrten Unterseite mit in die Zahnung 40 der Stützschienen eingreifenden weiteren symmetrisch angeordneten Vorsprüngen 41a bzw. 41b ausgebildet. Schließlich sind die Führungsschienen auf der Unterseite noch in der Mitte ihrer Länge mit einem Zentriersteg 42 ausgebildet und in der T-Nut 15 der mittleren C-Profilschiene 14 zentriert.

**Patentansprüche**

1. Einrichtung zur Führung elektrischer Inneneinbauten, wie z.B. Leiterplatten, Steckbaugruppen oder Einschübe, mit zwei einander gegenüberliegenden Profil-Trägerplatten sowie mit mindestens zwei parallel und senkrecht übereinander liegenden, aus elastischem Kunststoff bestehenden und mit einer Führungsnut für die Inneneinbauten versehenen Führungsschienen, die bezüglich einer ihre Länge halbierenden Ebene symmetrisch aufgebaut und an der der jeweiligen Profil-Trägerplatte zugekehrten Unterseite mit zwei entgegengesetzt gerichteten Einschnapphaken ausgebildet sind, die in jeweils eine Nut der jeweiligen Profil-Trägerplatte eingreifen, und mit zwei ein Teilungsraster aufweisenden, parallelen, senkrecht übereinander liegenden und senkrecht zu den Führungsschienen verlaufenden Rasterschienen, die je auf einer der Profil-Trägerplatten angeordnet sind, gekennzeichnet durch die Kombination folgender Merkmale:

a) die Führungsnut (25) der Führungsschienen (7) ist im Bereich beider Enden mit jeweils einem seitlichen Federarm (26a, 26b) ausgebildet, der an seinem freien Ende mit einer im entspannten Zustand in die Führungsnut (25) ragenden, widerhakenartig geformten Rastnase (27) versehen ist, die hinter eine Rastkante der Inneneinbauten greift, welche in einem im eingeschobenen Zustand am Anfang der Führungsnut liegenden Bereich der Inneneinbauten vorgesehen ist,

b) an beiden Enden der Führungsschienen (7) ist jeweils ein an der Stirnseite der Führungsschiene angeordneter, auf die jeweilige Profil-Trägerplatte (10) gerichteter Zentrierhaken (37a, 37b) vorgesehen,

c) die Führungsschienen (7) sind mit dem Zentrierhaken (37a bzw. 37b) in das Teilungsraster der vor der einen Stirnseite der Führungsschienen angeordneten Rasterschienen (6) bzw. in im Teilungsraster der Rasterschienen liegende Aussparungen (38) einer für die Verdrahtung der Inneneinbauten untereinander vor der anderen Stirnseite der Führungsschienen vorgesehenen Verdrahtungsplatte (8) eingehängt, so daß dadurch die Führungsschienen (7) seitlich im Teilungsraster fixiert sind und gleichzeitig die Verdrahtungsplatte (8) an der jeweiligen Profil-Trägerplatte (10) gehalten ist.

2. Einrichtung nach Anspruch 1, dadurch gekennzeichnet, daß die Führungsnut (25) der Führungsschienen (7) im Verlauf ihrer Längserstreckung mit zwei weiteren Federarmen (29a, 29b) ausgebildet ist, die an ihrem freien Ende eine im entspannten Zustand in die Führungsnut (25) ragende Nase (30) aufweisen.

3. Einrichtung nach Anspruch 2, dadurch gekennzeichnet, daß die Führungsschienen (7) an dem freien Ende der weiteren Federarme (29a, 29b) mit jeweils einer Aussparung (31) ausgebildet sind, in die jeweils eine weitere Verdrahtungsplatte (8a, 8b) in einer Zwischenebene einsetzbar ist.

4. Einrichtung nach Anspruch 3, dadurch gekennzeichnet, daß die Aussparungen (31) der Führungsschienen (7) in einem Bereich vorgesehen sind, der bei in die jeweilige Profil-Trägerplatte (10) eingesetztem Zustand über der Öffnung einer T-Nut (15) einer C-Profilschiene (14) der Profil-Trägerplatte liegt.

5. Einrichtung nach Anspruch 3 oder 4, dadurch gekennzeichnet, daß anschließend an die Aussparungen (31) zusätzliche, sich in Längsrichtung der Führungsschienen (7) erstreckende, seitliche Federarme (32a, 32b) der Führungsnut (25) vorgesehen und ohne Rastnase ausgebildet sind.

6. Einrichtung nach einem der vorhergehenden Ansprüche, dadurch gekennzeichnet, daß die Federarme (26a, 26b; 29a, 29b; 32a, 32b) durch Ausnehmungen (33, 34, 35) der Führungsschienen (7) gebildet sind.

7. Einrichtung nach einem der vorhergehenden Ansprüche, dadurch gekennzeichnet, daß die Führungsnut (25) seitlich einer sich in Längsrichtung der Führungsschienen (7) erstreckenden Symmetrielinie verläuft.

8. Einrichtung nach Anspruch 7, dadurch gekennzeichnet, daß die Zentrierhaken (37a, 37b) auf der anderen Seite der Symmetrielinie liegend vorgesehen sind.

9. Einrichtung nach Anspruch 8, dadurch gekennzeichnet, daß die an der Unterseite der Führungsschienen (7) vorgesehenen Einschnapphaken (36a, 36b) und die Zentrierhaken (37a, 37b) in einer Flucht liegend angeordnet sind.

10. Einrichtung nach einem der Ansprüche 7 bis 9, dadurch gekennzeichnet, daß die Zentrierhaken (37a, 37b) zur Führungsnut (25) der Führungsschienen (7) seitlich um eine Teilung des Rastermaßes versetzt sind, so daß eine Führungsschiene in eine Aussparung (38) der Verdrahtungsplatte (8) bzw. in eine Rasterschiene (6) unter zwei verschiedenen Teilungen des Teilungsrasters einsetzbar ist.

11. Einrichtung nach einem der vorhergehenden Ansprüche, dadurch gekennzeichnet, daß die Führungsschienen (7) an der der jeweiligen Profil-Trägerplatte (10) zugekehrten Unterseite mit Vorsprüngen (41a, 41b) ausgebildet sind, die in eine im Teilungsraster vorgesehene Zahnung (40) von Stützschienen (39) eingreifen.

12. Einrichtung nach einem der vorhergehenden Ansprüche, dadurch gekennzeichnet, daß die Führungsschienen (7) an der der jeweiligen Profil-Trägerplatte (10) zugekehrten Unterseite in der Mitte ihrer Länge mit einem Zentriersteg (42) ausgebildet sind.

13. Einrichtung nach einem der vorhergehenden Ansprüche, dadurch gekennzeichnet, daß die Aussparungen (38) in der Verdrahtungsplatte (8) von sich in ihrer Längsrichtung senkrecht zur Ebene der Profil-Trägerplatte (10) erstreckenden Langlöchern gebildet sind.

14. Einrichtung nach Anspruch 13, dadurch gekennzeichnet, daß die Länge der Langlöcher (38) etwa mindestens gleich der Höhe (h) der Zentrierhaken (37a, 37b) und die Breite der Langlöcher etwa gleich der lichten Außenweite der Zentrierhaken der Führungsschienen (7) ist.

15. Einrichtung nach Anspruch 13 oder 14, dadurch gekennzeichnet, daß die Langlöcher (38) in Höhe der auf C-Profilschienen (14) der jeweiligen Profil-Trägerplatte (10) aufliegenden Führungsschienen (7) angeordnet sind.

16. Einrichtung nach einem der vorhergehenden Ansprüche, dadurch gekennzeichnet, daß das Teilungsraster der Rasterschienen (6) als Lochraster mit sich in Einschubrichtung der Inneneinbauten erstreckenden langlochähnlichen Aussparungen (23) ausgebildet ist.

## Claims

1. Device for guiding internal electrical assemblies, such as circuit boards, plug-in modules or slide-in modules for example, having two mutually opposite sectional carrier plates and having at least two guide rails which lie parallel and vertically above one another, are made of resilient plastic and are provided with a guide groove for the internal assemblies, are constructed symmetrically with respect to a plane halving their length and which are designed at the underside facing the respective sectional carrier plate with two oppositely directed snap-in hooks, which each engage in a groove of the respective sectional carrier plate, and having two grid rails which have a graduated grid, lie parallel vertically above one another and run at right angles to the guide rails, and which are each arranged on one of the sectional carrier plates, characterized by the combination of the following features:
   a) the guide groove (25) of the guide rails (7) is designed in the region of both ends with a lateral spring arm (26a, 26b) in each case, which is provided at its free end with a barb-shaped detent nose (27) which juts in the relaxed state into the guide groove (25) and which engages behind a locating edge of the internal assemblies that is provided in a region of the internal assemblies lying at the beginning of the guide groove in the inserted state,
   b) at both ends of the guide rails (7) there is provided in each case a centring hook (37a, 37b) arranged on the end face of the guide rail and directed towards the respective sectional carrier plate (10),
   c) with the centring hook (37a or 37b) the guide rails (7) are hung into the graduated grid of the grid rails (6) arranged in front of the one end face of the guide rails, or are hung into cutouts (38), made in the graduated grid of the grid rails, of a wiring plate (8) provided for the wiring of the internal assemblies to one another in front of the other end face of the guide rails, so that the guide rails (7) are thereby laterally fixed in the graduated grid and at the same time the wiring plate (8) is held on the respective sectional carrier plate (10).

2. Device according to Claim 1, characterized in that the guide groove (25) of the guide rails (7) is designed in the course of its longitudinal extension with two further spring arms (29a, 29b), which have at their free end a nose (30) jutting into the guide groove (25) in the relaxed state.

3. Device according to claim 2, characterized in that the guide rails (7) are designed at the free end of the further spring arms (29a, 29b) with in each case one cutout (31), into each of which a further wiring plate (8a, 8b) can be inserted in an intermediate plane.

4. Device according to Claim 3, characterized in that the cutouts (31) of the guide rails (7) are provided in a region which lies above the opening of a T-groove (15) of a C-section rail (14) of the sectional carrier plate in the state when they are inserted into the respective sectional carrier plate (10).

5. Device according to Claim 3 or 4, characterized in that additional, lateral spring arms (32a, 32b) of the guide groove (25) extending in the longitudinal direction of the guide rails (7) are provided subsequent to the cutouts (31) and are designed without a detent nose.

6. Device according to one of the preceding claims, characterized in that the spring arms (26a, 26b; 29a, 29b, 32a, 32b) are formed by recesses (33, 34, 35) in the guide rails (7).

7. Device according to one of the preceding claims, characterized in that the guide groove (25) runs laterally with respect to a line of symmetry extending in the longitudinal direction of the guide rails (7).

8. Device according to Claim 7, characterized in that the centring hooks (37a, 37b) are provided lying on the other side of the line of symmetry.

9. Device according to Claim 8, characterized in that the snap-in hooks (36a, 36b) provided on the underside of the guide rails (7) and the centring hooks (37a, 37b) are arranged to lie in alignment.

10. Device according to one of Claims 7 to 9, characterized in that the centring hooks (37a, 37b) are offset laterally by one spacing of the grid with respect to the guide groove (25) of the guide rails (7), so that a guide rail can be inserted into a cutout (38) of the wiring plate (8) or into a grid rail (6) under two different spacings of the graduated grid.

11. Device according to one of the preceding claims, characterized in that the guide rails (7) are designed on the underside facing the respective sectional carrier plate (10) with projections (41a, 41b) which engage with teeth (40), provided in the graduated grid, of support rails (39).

12. Device according to one of the preceding claims, characterized in that the guide rails (7) are designed on the underside facing the respective sectional carrier plate (10) in the middle of their length with a centring web (42).

13. Device according to one of the preceding claims, characterized in that the cutouts (38) in the wiring plate (8) are formed by oblong holes extending in their longitudinal direction at right angles to the plane of the sectional carrier plate (10).

14. Device according to Claim 13, characterized in that the length of the oblong holes (38) is approximately at least equal to the height (h) of the centring hooks (37a, 37b) and the width of the oblong holes is approximately equal to the clear outer width of the centring hooks of the guide rails (7).

15. Device according to Claim 13 or 14, characterized in that the oblong holes (38) are arranged at the level of the guide rails (7) lying on C-section rails (14) of the respective sectional carrier plate (10).

16. Device according to one of the preceding claims, characterized in that the graduated grid of the grid rails (6) is designed as a perforated grid with oblong-hole-like cutouts (23) extending in the slide-in direction of the internal assemblies.

**Revendications**

1. Dispositif pour guider des éléments électriques intérieurs, comme par exemple des cartes à circuits imprimés, des sous-ensembles embrochables ou des tiroirs, comprenant deux plaques supports profilées situées l'une en face de l'autre, ainsi qu'au moins deux glissières parallèles en matière plastique élastique situées verticalement l'une audessus de l'autre et présentant une cannelure de guidage pour les éléments intérieurs, glissières qui ont une construction symétrique par rapport à un plan divisant leur longueur en deux parties égales et dont le côté inférieur, dirigé vers la plaque-support profilée correspondante est pourvu de deux crochets d'encliquetage dirigés vers des côtés opposés et qui s'étendent chacun dans une rainure de la plaque-support profilée correspondante, de même que deux rails-échelles parallèles, dont les divisions correspondent aux pas d'une grille de base, qui sont situés verticalement l'un au-dessus de l'autre et sont perpendiculaires aux glissières, chaque railéchelle étant disposé sur l'une des plaques supports profilées, caractérisé par la combinaison des particularités suivantes:

   a) la cannelure de guidage (25) des glissières (7) est pourvue, dans la région de chacune des deux extrémités, d'un bras élastique latéral (26a, 26b) qui est pourvu à son extrémité libre d'un tenon d'arrêt (27) en forme de crochet, faisant saillie à l'état détendu dans la cannelure (25) et venant se placer derrière un bord formant dispositif d'arrêt des éléments intérieurs, et qui est prévu dans une partie des éléments intérieurs située au début de la cannelure lorsque les éléments intérieurs ont été glissés en place,

   b) un crochet de centrage (37a, 37b) est prévu à chacune des deux extrémités des glissières (7), où il est disposé sur la face d'extrémité de la glissière en étant dirigé vers la plaque-support profilée (10) correspondante,

   c) les glissières (7) sont suspendues par un crochet de centrage (37a ou 37b) dans l'échelle du rail (6) disposé devant l'une des faces d'extrémité des glissières et par l'autre crochet de centrage dans des évidements (38) ménagés suivant la grille de base des rails-échelles dans un panneau de câblage (8) prévu pour le câblage des éléments intérieurs entre eux et disposé devant l'autre face d'extrémité des glissières, de sorte que les glissières (7) sont ainsi fixées latéralement dans la grille de base et que, en même temps, le panneau de câblage (8) est maintenu sur la plaque-support profilée (10) correspondante.

2. Dispositif selon la revendication 1, caractérisé en ce que la cannelure de guidage (25) des glissières (7) est pourvu, sur son étendue longitudinale, de deux bras élastiques supplémentaires (29a, 29b) qui présentent à leur extrémité libre un renflement (30) faisant saillie dans la cannelure (25) à l'état détendu.

3. Dispositif selon la revendication 2, caractérisé en ce que les glissières (7) présentent, au droit de l'extrémité libre des bras élastiques supplémentaires (29a, 29b), une encoche (31) dans laquelle peut être placé, dans un plan intermédiaire, un panneau de câblage supplémentaire (8a, 8b).

4. Dispositif selon la revendication 3, caractérisé en ce que les encoches (31) des glissières (7) sont prévues dans une zone située au-dessus de l'ouverture d'une rainure en T (15) d'un rail profilé en C (14) de la plaque-support profilée lorsque la glissière a été mise en place dans la plaque-support profilée concernée.

5. Dispositif selon la revendication 3 ou 4, caractérisé en ce que des bras élastiques latéraux, additionnels, (32a, 32b) de la cannelure de guidage (25), s'étendant dans le sens de la longueur des glissières (7), sont prévus à la suite des encoches (31) et sont dépourvus de tenons d'arrêt.

6. Dispositif selon une des revendications précédentes, caractérisé en ce que les bras élastiques (26a, 26b; 29a, 29b, 32a, 32b) sont délimités par des alvéoles (33, 34, 35) ménagées dans les glissières (7).

7. Dispositif selon une des revendications précédentes, caractérisé en ce que la cannelure de guidage (25) est située à côté d'une ligne de symétrie s'étendant dans le sens de la longueur des glissières (7).

8. Dispositif selon la revendication 7, caractérisé en ce que les crochets de centrage (37a, 37b) sont situés de l'autre côté de la ligne de symétrie.

9. Dispositif selon la revendication 8, caractérisé en ce que les crochets d'encliquetage (36a, 36b), prévus sur le côté inférieur des glissières (7), sont alignés avec les crochets de centrage (37a, 37b).

10. Dispositif selon une des revendications 7 à 9, caractérisé en ce que les crochets de centrage (37a, 37b) sont décalés latéralement d'un pas de la grille de base par rapport à la cannelure de guidage (25) des glissières (7), de sorte qu'une glissière peut être mise en place dans un évidement (38) du panneau de câblage (8) et dans un rail-échelle (6) à des endroits mutuellement décalés d'un pas de la grille de base.

11. Dispositif selon une des revendications précédentes, caractérisé en ce que les glissières (7) sont pourvues, sur le côté inférieur dirigé vers la plaque-support profilée (10) correspondante, de saillies (41a, 41b) qui pénètrent dans un crantage (40) réalisé conformément à la grille de base dans des rails d'appui (39).

12. Dispositif selon une des revendications précédentes, caractérisé en ce que les glissières (7) sont pourvues, sur le côté inférieur dirigé vers la plaque-support profilée (10) correspondante, d'une barrette de centrage (42) située au milieu de la longueur de la glissière.

13. Dispositif selon une des revendications précédentes, caractérisé en ce que les évidements (38) ménagés dans le panneau de câblage (8), sont formés par des trous oblongs dont la direction longitudinale est perpendiculaire au plan de la plaque-support profilée (10).

14. Dispositif selon la revendication 13, caractérisé en ce que la longueur des trous oblongs (38) est au moins égale, approximativement, à la hauteur (h) des crochets de centrage (37a, 37b) et la largeur des trous oblongs est.à peu près égale à la largeur hors tout des crochets de centrage des glissières (7).

15. Dispositif selon la revendication 13 ou 14, caractérisé en ce que les trous oblongs (38) sont situés à la hauteur des glissières (7) reposant sur des rails profilés en C (14) de la plaque-support profilée (10) correspondante.

16. Dispositif selon une des revendications précédentes, caractérisé en ce que l'échelle des rails (6) est formée par une perforation régulière constituée par des évidements (23) semblables à des trous oblongs qui s'étendent dans la direction d'introduction des éléments intérieurs.

# FIG 1

# FIG 2

# FIG 3

# FIG 4

EP 0 217 161 B1